# EUROPEAN PATENT SPECIFICATION

(11) **EP 0 333 995 B1**
(45) Date of publication and mention of the grant of the patent: **27.07.1994**
(21) Application number: 89101222.1
(22) Date of filing: 25.01.1989
(51) Int. Cl.: B23C 3/12

(54) **An apparatus of chamfering planar plate**
Gerät zur Kantenbearbeitung von Platten
Appareil pour le chanfreinage de plaques

(30) Priority: 23.03.1988 JP 68677/88
(43) Date of publication of application: 27.09.1989
(73) Proprietor: Nippon CMK Corp., Iruma-Gun Saitama (JP)
(72) Inventor: Seki, Kameharu, Kawagoe-shi Saitama (JP); Kubo, Isamu, Isesaki-shi Gunma (JP)
(74) Representative: Schickedanz, Willi, Dipl.-Ing.

(56) References cited:
- PATENT ABSTRACTS OF JAPAN vol. 10, no. 37 (M-453)(2094) 14 February 1986,& JP-A-60 191710 (NIHON SHII EMU KEI K.K.) 30 September 1985,
- PATENT ABSTRACTS OF JAPAN vol. 5, no. 29 (M-56)(701) 21 February 1981,& JP-A-55 157417 (TOKYO SHIBAURA DENKI K.K.) 8 December 1980,

## Description

The present invention relates to an apparatus according to the preamble of claim 1.

### Description of the Prior Art

An apparatus for chamfering printed circuit boards is already known (Patents Abstracts of Japan, Vol. 10, No. 37 (M-453) (2094) 14 February 1986 & J-A-60191710, Nihon Shii Emu Kei K. K., 30 September 1985). In this apparatus a number of printed circuit boards are loaded onto the loading surface of a surface plate so that each terminal part is set upwardly. The circuit boards are attached so as to be leaned against each other successively and arranged aslantly in rectilinear form and fixed. A twist drill is transferred in parallel to the loading surface, and the chamfering for one edge of the terminal part is completed.

Still, an apparatus for chamfering the edges of stacked plates is known which chamfers the outer edges of adjacent stacked plates simultaneously (SU-A-1 271 678 representing the closest prior art).

### Disadvantage of the Prior Art

The disadvantage of the prior art lies either in the fact that the plates cannot be stacked one above the other or that it is not easily possible to detect the boarders of adjacent stacked plates.

### Technical Problem

The object of the present invention is to eliminate or at least mitigate the above mentioned disadvantages and to provide an improved apparatus of chamfering planar plate, so that the chamfering process is performed to a plurality of stacked plates and positioning errors and warp problems are not caused.

### Solution of the Technical Problem

According to the present invention the above problem is solved by the combination of the features of claim 1.

### Advantageous Effects of the Invention

As the plates are stacked, positioning of the plates is one for stacked plates and no reverse process is necessary. As the border between two stacked plates is detected precisely, the tool guide is accurately performed and the edges to be chamfered are accurately determined. As the tool forms V-shaped grooves, no reverse problem occurs. The apparatus performs accurate chamfering in a very short time period, even if the plates to be chamfered include thickness variety.

Whereas conventional chamfering processes need about 3 - 5 seconds per sheet and the chamfer result is not sufficient, the present process performs sufficiently accurate chamfering in about 1/3 of the time.

### Brief Description of the Drawings

Figure 1 is a schematic side view of the chamfering apparatus according to the present invention, a portion of which is broken away.
Figures 2A, 2B and 2C are plan views showing an arrangement of stacked plates and working tools, and
Figure 3 is similar to Fig. 2 whereby four tools are provided.

### Detailed Description of the Preferred Embodiment

As to chamfering apparatus, the present invention is not merely an improvement of the prior art, since resembled prior art cannot be found.

Now, a preferred embodiment of the present invention as a printed wiring boards chamfering apparatus will be described referring to the drawings.

The printed wiring boards chamfering apparatus includes a stacking device, an aligning device, a border detecting device, a chamfering device, a turning device and a discharge device.

The stacking device stacks a plurality, e. g. 10 to 250 sheets, of base plates which are cut by a cutting machine in a suitable container of easily disassembled.

At the aligning device, the plates are pushed from both sides to be in parallel with each other, and they are pushed from above to maintain stacked state. Then they are supplied to the chamfering device.

The border detecting device detects the border between adjacent plates by means of CCD camera or a proximate sensor detecting copper film which covers the printed wiring board at the chamfering station.

The chamfering device utilizes a numerical control device to move the V-shaped tool to align the tool precisely to the detected border and corrects the copper film thickness of 17 - 35 µm so that the center of the tool precisely aligns with center of the border. Then the cutter moves along the border cutting the lower edge of the upper plate and the upper edge of the lower plate by one movement of the cutter.

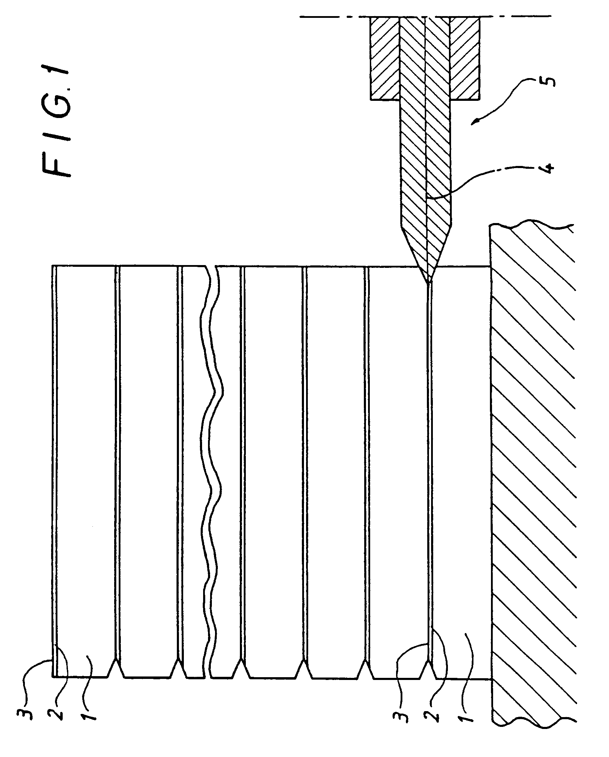

The cutting process is shown in Fig. 1. A copper film 2 on a stacked base plate 1 is detected by a detecting device, not shown, and center line 4 of a tool 5 is aligned with the border line 3 on the copper film 2. The included angle of the tool may be between 45 - 90° and the tool cut along the border desired depth such as shown in Fig. 1. Cutting is performed sequentially from below. Of course, when both surfaces of the base plate are clad with copper film, the above mentioned correction of copper thickness is not necessary.

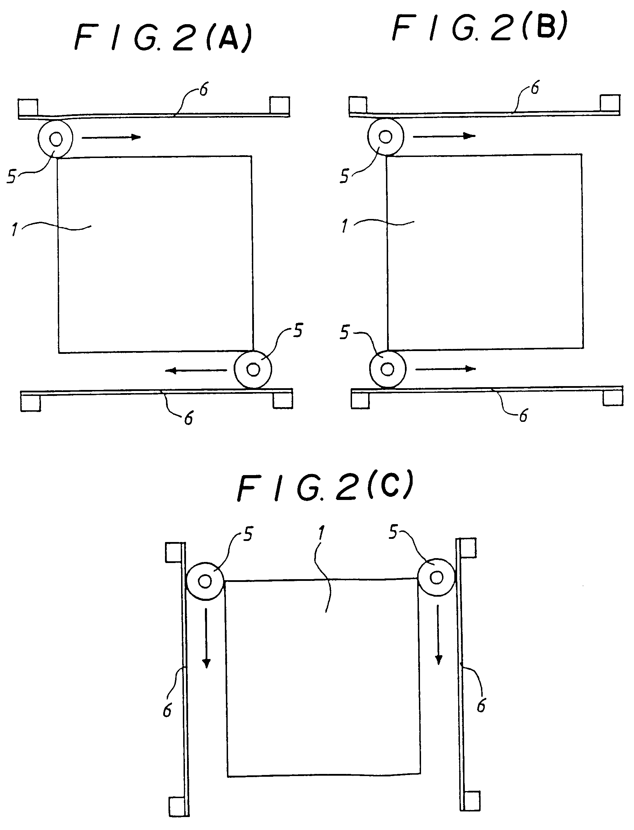

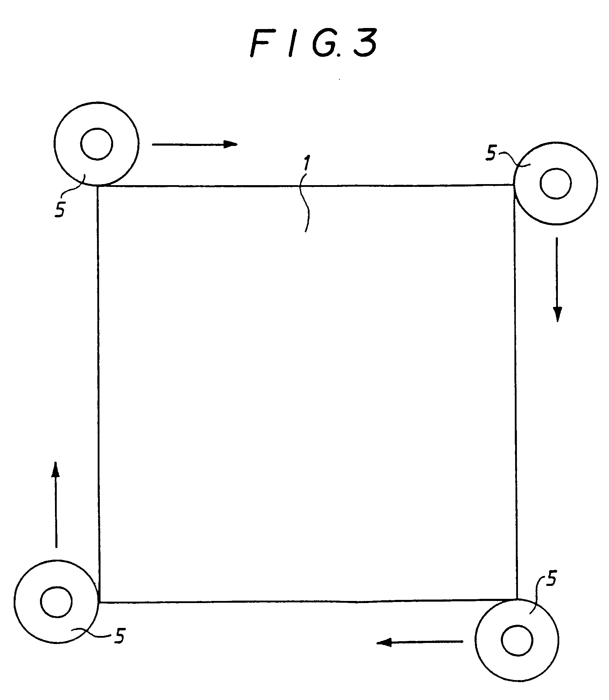

When chamfer cutting reaches to uppermost plate, the turning device turns the stack of plates at 90° to face the tool 5 next surface of the stack of plates 1. As shown in Fig. 2, when two sets of tools are used, one turning is sufficient to chamfer four edges of the plates, and when four sets of tools are utilized as shown in Fig. 3, no turning is necessary to complete chamfer work. In this case, 250 sheets can be chamfered in about 5 minutes. A tool hold and moving device 6 is shown in Fig. 2.

After complete chamfering of eight edges of the plates, the base plates are conveyed to a discharge device where the plates are prepared for a next process not related to the present invention.

In the drawings shown, a rotary cutter is used to perform 45° chamfer. Other desired tool e. g. end mill can be used to perform 90° chamfer. Angle and depth of the chamfer can be selected as desired.

The present invention concerns the chamfering of stacked printed wiring boards as a preferred embodiment. Nonmetallic plates having metal film can be chamfered by utterly the same process. Other plates can be chamfered by utilizing necessary border detect devices having the desired accuracy.

As described, by chamfering the plates in stacked condition, production efficiency is remarkably improved. Flatness of plates is maintained sufficiently, so that warp or incorrect chamfer is not produced.

Instead of mechanical cutting means also beam cutting means may be used, such as laser beams or beams of ions or electrons, respectively.

## Claims

1. An apparatus for chamfering the edges of stacked plates comprising chamfering means (5) positionable adjacent to opposed outer edges of respective ones of two adjacent stacked plates (1) and relatively movable along the opposed outer edges for simultaneously chamfering both opposed edges, **characterized by** contactless detecting means for detecting the boundary between two adjacent stacked plates in a stack of plates and for controlling said chamfering means (5).

2. An apparatus according to claim 1, **characterized in that** the contactless detecting means comprises a CCD camera.

3. An apparatus according to claim 1, **characterized in that** the contactless detecting means comprises a sensor for detecting the presence of a metal film on the major surface of one of the two adjacent stacked plates.

4. An apparatus according to claim 1, **characterized in that** the chamfering means comprises a rotary working tool having a tapered cutting edge.

5. An apparatus according to claim 1, **characterized in that** the chamfering means comprises a working tool, and a positioning device for positioning the working tool adjacent opposed edges of respective ones of the two adjacent stacked plates in response to detection of the boundary.

6. An apparatus according to claim 1, **characterized in that** the center line (4) of a tool (5) is aligned with a border line (3) on a copper film (2).

7. An apparatus according to claim 6, **characterized in that** the cutting portion of the tool (5) includes an angle between 45° and 90°.

8. An apparatus according to claim 1, **characterized in that** the depth of the cut portion of the plate (1) is about 1/20 of the total width of the plate (1).

9. An apparatus according to claim 1, **characterized in that** two sets of tools (5) are used together with turning means which turns the stacked plates about 90°.

10. An apparatus according to claim 1, **characterized in that** the tool (5) comprises a rotary disk the end of which consists of cutting means having an angle between 45° and 90°, said disk being movable along a vertical axis, thus cutting two edges of the lowermost plates simultaneously up to the edges of the uppermost plates.

## Patentansprüche

1. Vorrichtung zum Abschrägen der Kanten von aufeinanderliegenden Platten, umfassend eine Abschrägvorrichtung (5), die in der Nähe von sich gegenüberliegenden äußeren Kanten von jeweils zwei benachbarten aufeinanderliegenden Platten (1) angeordnet werden kann und entlang der sich gegenüberliegenden äußeren Kanten relativ bewegbar ist, um beide sich gegenüberliegenden Kanten gleichzeitig abzuschrägen, **gekennzeichnet durch** eine berührungslose Erkennungsvorrichtung zum Erkennen der Grenze zwischen benachbarten aufeinanderliegenden Platten in einem Plattenstapel und zur Steuerung der Abschrägvorrichtung (5).

2. Vorrichtung nach Anspruch 1, **dadurch gekennzeichnet**, daß die berührungslose Erkennungsvorrichtung eine CCD-Kamera umfaßt.

3. Vorrichtung nach Anspruch 1, **dadurch gekennzeichnet**, daß die berührungslose Erkennungsvorrichtung einen Sensor zur Erkennung des Vorhandenseins eines Metallfilms auf der Hauptfläche einer der zwei benachbarten aufeinanderliegenden Platten umfaßt.

4. Vorrichtung nach Anspruch 1, **dadurch gekennzeichnet**, daß die Abschrägvorrichtung ein sich drehendes Arbeitswerkzeug mit einer konischen Schneidkante umfaßt.

5. Vorrichtung nach Anspruch 1, **dadurch gekennzeichnet**, daß die Abschrägvorrichtung ein Arbeitswerkzeug umfaßt und eine Positioniereinrichtung zum Positionieren des Arbeitswerkzeugs in der Nähe der sich gegenüberliegenden Kanten von jeweils zwei benachbarten aufeinanderliegenden Platten entsprechend der Erkennung der Grenze.

6. Vorrichtung nach Anspruch 1, **dadurch gekennzeichnet**, daß die Mittellinie (4) eines Werkzeugs (5) mit einer Randlinie (3) auf einer Kupferschicht (2) fluchtet.

7. Vorrichtung nach Anspruch 6, **dadurch gekennzeichnet**, daß der Schneidbereich des Werkzeugs (5) einen Winkel zwischen 45° und 90° einschließt.

8. Vorrichtung nach Anspruch 1, **dadurch gekennzeichnet**, daß die Tiefe des ausgeschnittenen Bereichs der Platte (1) etwa 1/20 der Gesamtbreite der Platte (1) beträgt.

9. Vorrichtung nach Anspruch 1, **dadurch gekennzeichnet**, daß zwei Sätze von Werkzeugen (5) zusammen mit einer Drehvorrichtung benutzt werden, welche die aufeinanderliegenden Platten um 90° dreht.

10. Vorrichtung nach Anspruch 1, **dadurch gekennzeichnet**, daß das Werkzeug (5) eine Drehscheibe umfaßt, deren Ende aus einer Schneidvorrichtung mit einem Winkel zwischen 45° und 90° besteht, wobei die Scheibe entlang einer vertikalen Achse verschiebbar ist, wodurch sie gleichzeitig zwei Kanten der untersten Platten bis zu den Kanten der obersten Platten abschneidet.

## Revendications

1. Appareil de biseautage des bords de plaques empilées, comprenant des moyens de biseautage (5) disposés au voisinage des bords externes opposés des plaques respectives de deux plaques empilées voisines (1) et susceptibles de se déplacer le long des bords externes opposés pour biseauter simultanément les deux bords opposés, caractérisé par des moyens de détection sans contact pour détecter la limite entre deux piles empilées voisines d'une pile de plaques et pour commander lesdits moyens de biseautage (5).

2. Appareil selon la revendication 1, caractérisé en ce que les moyens de détection sans contact comprennent un appareil photographique CCD.

3. Appareil selon la revendication 1, caractérisé en ce que les moyens de détection sans contact comprennent un capteur permettant de détecter la présence d'un film métallique sur la surface principale de l'une des deux plaques empilées voisines.

4. Appareil selon la revendication 1, caractérisé en ce que les moyens de biseautage comprennent un outil de travail rotatif comportant une arête coupante effilée.

5. Appareil selon la revendication 1, caractérisé en ce que les moyens de biseautage comprennent un outil de travail et un dispositif de positionnement pour positionner l'outil de travail au voisinage des bords opposés des plaques respectives des deux plaques empilées voisines en réponse à la détection de la limite.

6. Appareil selon la revendication 1, caractérisé en ce que l'axe (4) d'un outil (5) est aligné avec une ligne limite (3) sur un film de cuivre(2).

7. Appareil selon la revendication 6, caractérisé en ce que la partie coupante de l'outil (5) comprend un angle compris entre 45 et 90°.

8. Appareil selon la revendication 1, caractérisé en ce que la profondeur de la partie découpée de la plaque (1) est d'environ 1/20 de la largeur totale de la plaque (1).

9. Appareil selon la revendication 1, caractérisé en ce que deux jeux d'outils (5) sont utilisés conjointement avec des moyens rotatifs qui font tourner les plaques empilées d'environ 90°.

10. Appareil selon la revendication 1, caractérisé en ce que l'outil (5) comprend un disque rotatif dont l'extrémité est constituée de moyens de coupe ayant un angle compris entre 45 et 90°, ledit disque pouvant être déplacé le long d'un axe vertical, coupant de la sorte deux bords des plaques inférieures simultanément jusqu'au bords des plaques supérieures.
